# DEMANDE DE BREVET EUROPEEN

(11) **EP 1 901 428 A1**
(43) Date de publication de la demande: **19.03.2008**
(21) Numéro de dépôt: 07115966.9
(22) Date de dépôt: 07.09.2007
(51) Int. Cl.: H03K 5/1252, H03K 5/1534, H03K 17/61

(54) **Transfert de données numériques à travers un transformateur**

(30) Priorité: 14.09.2006 FR 0653735
(71) Demandeur: ST MICROELECTRONICS S.A., 92120 Montrouge (FR)
(72) Inventeur: Florence, Arnaud, 37360 Saint Antoine du Rocher (FR)
(74) Mandataire: de Beaumont, Michel

(57) **Abrégé**

L'invention concerne un procédé et un système de transfert d'un signal numérique à travers un transformateur (11), comportant un circuit de codage du signal numérique à transférer, dont deux sorties sont reliées aux extrémités respectives d'un enroulement primaire (11p) du transformateur, et un circuit de décodage (33) du courant dans un enroulement secondaire (11s) du transformateur générant un front montant, respectivement descendant, d'un signal de sortie selon le sens d'impulsions de courant détectées.

## Description

### Domaine de l'invention

La présente invention concerne de façon générale les barrières d'isolement galvanique et, plus particulièrement, la transmission de signaux numériques à travers une barrière d'isolement.

### Exposé de l'art antérieur

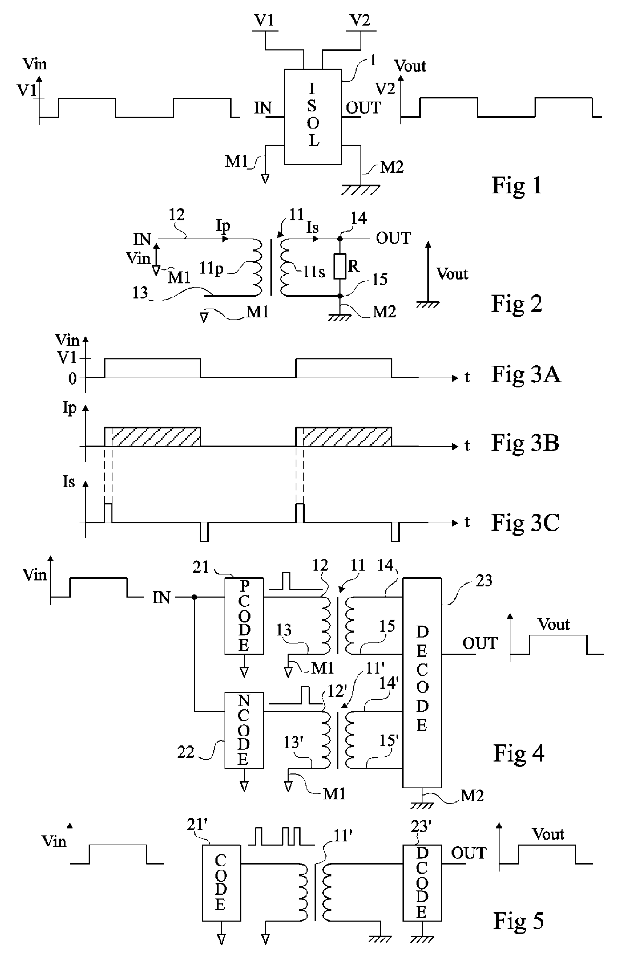

La figure 1 représente, de façon très schématique et sous forme de blocs, un exemple de système d'isolement ou isolateur 1 (ISOL) du type auquel s'applique la présente invention. Cet isolateur reçoit, sur une borne d'entrée IN, un signal numérique Vin ayant pour amplitude une première tension V1 référencée par rapport à une première masse M1, et sur une borne de sortie OUT, un signal numérique Vout ayant pour amplitude une deuxième tension V2 référencée par rapport à une deuxième masse M2. Les amplitudes V1 et V2 peuvent être différentes ou identiques.

Pour obtenir un isolement galvanique, on a généralement recours à des optocoupleurs, des coupleurs capacitifs ou des transformateurs.

La présente invention s'applique plus particulièrement à un isolement à base de transformateur.

La figure 2 représente un premier exemple de schéma connu d'un transformateur 11. Un enroulement primaire 11p du transformateur reçoit, sur une première extrémité 12, le signal Vin à convertir et a sa deuxième extrémité 13 reliée à la masse M1. Un enroulement secondaire 11s du transformateur a une première extrémité 14 définissant la borne OUT tandis qu'une deuxième extrémité 15 est reliée à la masse M2. Une résistance R de conversion courant-tension, aux bornes de laquelle est prélevé le signal Vout, relie les bornes de sortie 14 et 15.

Les figures 3A, 3B et 3C illustrent le fonctionnement du transformateur de la figure 2 pour la transmission d'un signal numérique Vin (par exemple, un signal d'horloge). La figure 3A représente un exemple d'allure du signal Vin. La figure 3B illustre l'allure du courant Ip dans le primaire 11p du transformateur. La figure 3C illustre l'allure du courant Is dans le secondaire 11s. Les fronts montants du signal Vin se traduisent par des impulsions dans un premier sens (par exemple positif avec les orientations prises aux figures) sur le courant Is. Les fronts descendants se traduisent par des impulsions dans le sens inverse. A partir du courant Is, un décodeur adapté est capable de reconstituer le signal d'horloge ayant traversé la barrière d'isolement.

Toutefois, un inconvénient du montage de la figure 2 est qu'il engendre une consommation importante. En effet, côté primaire, le transformateur est alimenté pendant tous les créneaux positifs alors que seuls les fronts sont exploités par le secondaire. Cette consommation inutile est illustrée en figure 3B par des hachures.

La figure 4 représente un premier exemple de solution visant à éviter cette consommation inutile.

Deux transformateurs 11 et 11' sont respectivement utilisés pour transmettre des fronts montants et descendants du signal d'entrée Vin. Pour cela, la borne IN d'entrée de l'isolateur est envoyée en entrée de deux circuits de codage 21 (PCODE) et 22 (NCODE) fournissant respectivement des impulsions sur les fronts montants et sur les fronts descendants du signal Vin. Les sorties des circuits 21 et 22 sont connectées à des premières extrémités respectives 12 et 12' des primaires des transformateurs 11 et 11' dont les deuxièmes extrémités respectives 13 et 13' sont reliées à la masse M1. Les extrémités respectives 14, 15 et 14', 15' des enroulements secondaires des transformateurs 11 et 11' sont reliées à un circuit 23 de décodage (DECODE) fournissant, sur une borne de sortie OUT, le signal Vout référencé par rapport à la masse M2.

Un inconvénient de l'isolateur de la figure 4 est qu'il requiert deux transformateurs, ce qui accroît l'encombrement et le coût.

La figure 5 représente un deuxième exemple de solution pour éviter une consommation excessive du transformateur.

Selon cet exemple, un circuit 21' (CODE) de codage du signal numérique Vin à traiter fournit, au primaire 11p d'un transformateur 11, une impulsion pour les fronts montants et une suite de deux impulsions rapprochées pour les fronts descendants. Un circuit de décodage 23' (DECODE) exploite, côté secondaire, les fronts et paires de fronts pour reconstituer le signal Vout.

Un inconvénient de l'isolateur de la figure 5 est qu'il requiert, côté décodage, une fenêtre d'observation déterminée pour être capable de distinguer les fronts montants des paires de fronts descendants qui se traduisent au secondaire par des impulsions dans le même sens. La fréquence du signal numérique susceptible d'être traitée, donc la bande passante du système, est ainsi limitée.

### Résumé de l'invention

La présente invention vise à pallier tout ou partie des inconvénients des transformateurs connus pour transférer des signaux numériques à travers une barrière d'isolement.

L'invention vise plus particulièrement une solution ne requérant qu'un seul transformateur.

L'invention vise également une solution exploitant des circuits de codage et de décodage simplifiés.

L'invention vise également une solution à large bande passante.

Pour atteindre tout ou partie de ces objets ainsi que d'autres, la présente invention prévoit un procédé de transfert d'un signal numérique à travers un transformateur, dans lequel le courant dans un enroulement primaire du transformateur est inversé selon le front montant ou descendant du signal numérique à transférer.

Selon un mode de mise en oeuvre de la présente invention, le signal numérique à transférer est codé pour générer des impulsions à chacun de ses fronts.

Selon un mode de mise en oeuvre de la présente invention, des fronts respectivement montants et descendants d'un signal de sortie sont générés selon le sens du courant dans un enroulement secondaire du transformateur.

L'invention prévoit également un système de transfert d'un signal numérique à travers un transformateur, comportant :
un circuit de codage du signal numérique à transférer, dont deux sorties sont reliées aux extrémités respectives d'un enroulement primaire du transformateur ; et
un circuit de décodage du courant dans un enroulement secondaire du transformateur générant un front montant, respectivement descendant, d'un signal de sortie selon le sens d'impulsions de courant détectées.

Selon un mode de réalisation de la présente invention, le circuit de codage comporte :
un premier inverseur associé à une première porte logique pour générer des impulsions sur les fronts montants ; et
des deuxième et troisième inverseurs associés à une deuxième porte logique pour générer des impulsions sur les fronts descendants.

Selon un mode de réalisation de la présente invention, les sorties respectives des premier et troisième inverseurs sont reliées à une ligne d'alimentation positive par des condensateurs.

Selon un mode de réalisation de la présente invention, le circuit de décodage comporte deux comparateurs dont les sorties sont reliées aux entrées respectives de mise à un et de remise à zéro d'une bascule dont une sortie fournit le signal numérique transféré.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 5 décrites précédemment sont destinées à exposer l'état de la technique et le problème posé ;
la figure 6 représente, de façon très schématique et sous forme de blocs, un premier mode de réalisation d'un système de transfert selon la présente invention ;
la figure 7 représente un premier mode de réalisation d'un circuit d'entrée du système de la figure 6 ;
la figure 8 représente un mode de réalisation d'un circuit de sortie du système de la figure 6 ; et
les figures 9A, 9B, 9C, 9D, 9E, 9F, 9G et 9H illustrent, par des chronogrammes, le fonctionnement du système représenté aux figures précédentes.

De mêmes éléments ont été désignés par de mêmes références aux différentes figures qui ont été tracées sans respect d'échelle. Par souci de clarté, seuls les éléments utiles à la compréhension de l'invention ont été représentés et seront décrits. En particulier, les circuits amonts et avals de la barrière d'isolement de l'invention, pour générer les signaux numériques et exploiter ces signaux, n'ont pas été détaillés, l'invention étant compatible avec tout système classique ayant besoin de faire transiter un signal numérique par une barrière d'isolement.

### Description détaillée

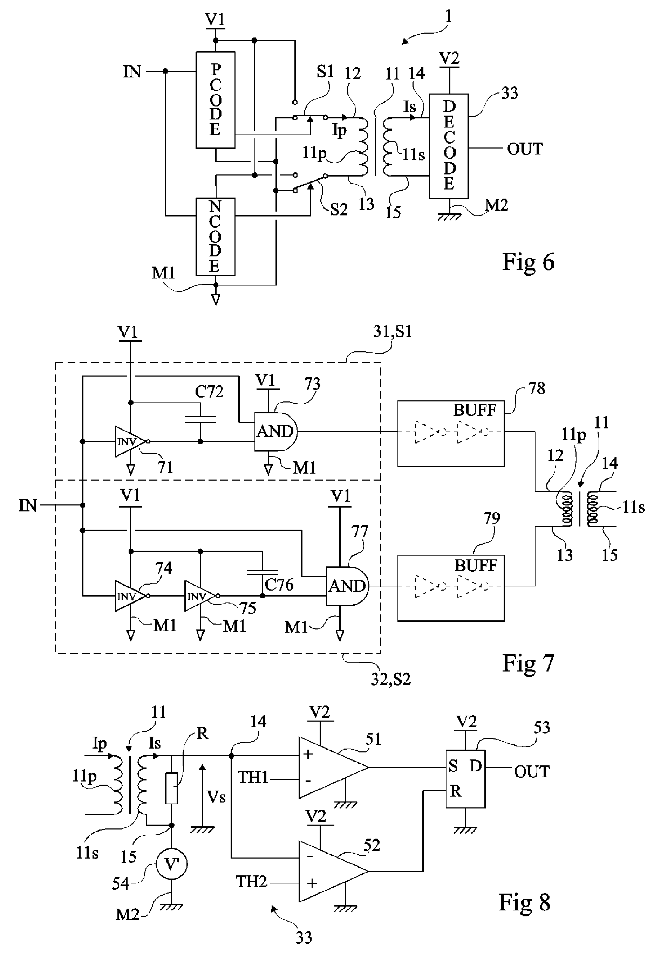

La figure 6 représente, de façon très schématique et sous forme de blocs, un mode de réalisation d'un système de transfert de signaux numériques à travers une barrière d'isolement selon la présente invention.

Une borne IN d'entrée recevant un signal Vin numérique à transmettre en aval de la barrière d'isolement est reliée aux entrées de deux codeurs 31 (PCODE) et 32 (NCODE) fournissant des impulsions d'amplitude V1, référencées à une première masse (ou potentiel de référence) M1, respectivement sur les fronts montants et descendants du signal numérique d'entrée. Les circuits 31 et 32 commandent deux sélecteurs S1 et S2 pour connexion sur commande des extrémités respectives 12 et 13 d'un enroulement primaire 11p d'un transformateur 11, soit à un niveau positif d'alimentation, soit à la masse M1. Le sélecteur S1 sélectionne la tension V1 en présence d'une impulsion représentant un front montant du signal d'entrée et la masse M1 autrement. De même, le sélecteur S2 sélectionne la tension V1 en présence d'une impulsion représentant un front descendant du signal Vin et la masse M1 autrement.

Ainsi, le sens du courant Ip dans le primaire 11p du transformateur 11 est inversé selon le sens du front présent sur le signal d'entrée Vin alors même que les circuits 31 et 32 fournissent tous deux des impulsions dans le même sens (par exemple positif) lorsqu'ils détectent un front respectivement montant ou descendant.

Côté secondaire 11s du transformateur, un circuit 33 de décodage (DECODE) fournit un signal de sortie sur une borne OUT représentant le signal numérique d'entrée. Le décodeur 33 régénère le signal numérique en exploitant les sens respectifs des impulsions présentes sur le courant Is de l'enroulement secondaire 11s.

La figure 7 représente un exemple de réalisation du circuit d'entrée du système de la figure 6, basé sur l'utilisation d'inverseurs (par exemple, des inverseurs CMOS). Dans cet exemple, le circuit 31 est constitué d'un inverseur 71 (INV) alimenté par la tension V1. L'entrée de l'inverseur (grilles communes des transistors à canal P et N en série entre les lignes d'alimentation V1 et M1) est reliée à la borne d'entrée IN. La sortie de l'inverseur est reliée à la ligne d'alimentation V1 par un condensateur C72 fixant un retard à la commutation de l'inverseur (donc la durée des impulsions positives sur les fronts montants). La sortie de l'inverseur 71 est reliée à une première entrée d'une porte logique de type ET 73 (AND) dont une deuxième entrée reçoit le signal IN. La porte 73 définit en quelque sorte le sélecteur S1.

Au repos (signal Vin à la masse M1), la sortie de l'inverseur 71 est au niveau haut. La sortie de la porte 73 est alors au niveau bas. Lorsqu'un front montant arrive sur l'entrée IN, la commutation de la sortie de l'inverseur 71 est retardée par le temps que met le condensateur C72 à se décharger dans la résistance série à l'état passant du transistor bas de l'inverseur. Comme la deuxième entrée de la porte 73 commute au niveau haut avant la décharge du condensateur 72, la sortie de la porte 73 commute au niveau haut. Lorsque le condensateur 72 est suffisamment déchargé, la porte 72 commute de nouveau au niveau bas. Tant que le signal Vin reste au niveau haut, la sortie de l'inverseur 71 fournit un niveau bas et la porte 73 reste au niveau bas.

Lors d'un front descendant du signal Vin, la commutation de l'inverseur 71 vers le niveau haut est quasi immédiate par le condensateur C72. De plus, ce front arrive sur la deuxième entrée de la porte ET 73 dont la sortie reste donc à l'état bas.

De ce qui précède, il ressort que la valeur du condensateur C72 est choisie pour introduire un retard supérieur au temps de propagation du signal jusqu'à la deuxième entrée de la porte 73.

Le cas échéant, une porte additionnelle (non représentée) est intercalée entre l'entrée IN et la deuxième entrée de la porte 73 pour former un élément d'activation commandé par un signal appliqué à l'autre entrée de cette porte additionnelle.

Une structure similaire est reproduite côté codeur 32 et sélecteur S2 à la différence près que deux inverseurs 74 et 75 sont en série entre l'entrée IN et une porte de type ET 77, un condensateur C76 reliant la sortie du deuxième inverseur 75 à la tension V1. La sortie de la porte 77 fournit des impulsions positives sur les fronts descendants du signal d'entrée IN.

Un avantage de ce mode de réalisation est sa simplicité pour alterner le sens des impulsions d'excitation du transformateur.

Les signaux de sortie des portes 73 et 77 peuvent être amplifiés par des circuits tampons (buffer) 78 et 79 (BUFF) constitués, par exemple, de plusieurs inverseurs en série (avec un même nombre d'inverseurs dans les circuits 78 et 79) de façon à augmenter le courant fourni à l'enroulement primaire 11p afin de rendre le système de transfert plus rapide.

La figure 8 représente un mode de réalisation d'un décodeur 33 du courant Is fourni par le secondaire 11s du transformateur 11. Ce décodeur est basé sur l'utilisation de deux comparateurs 51 et 52 dont les entrées non inverseuse et inverseuse respectives sont connectées à la borne 14 de l'enroulement secondaire 11s du transformateur 11. Une résistance R de conversion courant-tension relie les bornes 14 et 15. Les entrées inverseuse et non inverseuse respectives des comparateurs 51 et 52 reçoivent des tensions seuils TH1 et TH2. Les niveaux TH1 et TH2 peuvent être identiques ou légèrement différents et introduire alors une hystérésis bénéfique à une immunité au bruit. Les niveaux TH1 et TH2 sont choisis pour être franchis à chaque fois qu'une impulsion représentative d'un front est présente sur le courant du secondaire et pour filtrer les bruits parasites éventuels. La sortie du premier comparateur 51 est reliée à une première entrée (par exemple S de mise à 1) d'une bascule 53 dont la deuxième entrée (de réinitialisation R) est reliée à la sortie du comparateur 52. La sortie D de la bascule RS constitue la sortie OUT de l'isolateur. Les comparateurs et la bascule sont alimentés par la tension V2.

De préférence et comme l'illustre la figure 8, un régulateur de tension 54 est intercalé entre la borne 15 de l'enroulement secondaire et la masse M2 pour décaler la référence du noeud 15 d'une tension V' par rapport à la masse M2, afin que la tension Vs entre la borne 14 et la masse M2 reste positive.

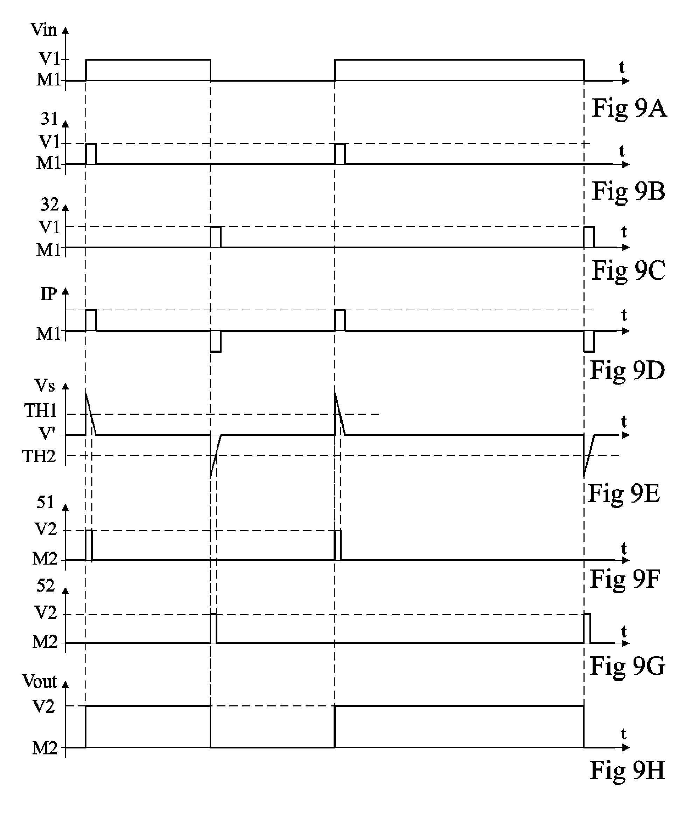

Les figures 9A à 9H illustrent, par des chronogrammes, le fonctionnement du système des figures 6 à 8.

La figure 9A représente un exemple de signal Vin numérique appliqué en entrée du système. Dans cet exemple arbitraire, le signal n'est pas un signal d'horloge mais un signal numérique par exemple de transmission de données.

La figure 9B illustre l'allure du signal fourni par le codeur 31 qui présente une impulsion de niveau V1 à chaque front montant du signal Vin. La durée de l'impulsion dépend de la constante de temps apportée par le condensateur C72 et la résistance série à l'état passant du transistor bas de l'inverseur 71. Pour simplifier la description, on a négligé les chutes de tension par rapport aux tensions d'alimentation respectives du primaire et du secondaire et on considère les signaux numériques comme ayant les pleines amplitudes de ces tensions d'alimentation. De même, on a négligé les temps de propagation des signaux.

La figure 9C représente l'allure du signal fourni en sortie du codeur 32 qui comporte une impulsion positive de niveau V1 à chaque front descendant du signal Vin. Pour une technologie d'inverseurs donnée, la durée de l'impulsion dépend de la valeur du condensateur C76. De préférence, les condensateurs C72 et C76 sont choisis de même valeur.

La figure 9D illustre l'allure du courant Ip dans le primaire du transformateur 11. En raison de l'inversion de la connexion de masse de cet enroulement primaire, les impulsions en sortie du codeur 31 se traduisent par des impulsions positives avec des orientations prises aux figures tandis que les impulsions présentes en sortie du codeur 32 se traduisent par des impulsions négatives.

La figure 9E illustre l'allure de la tension Vs récupérée côté secondaire du transformateur. Une impulsion positive par rapport au niveau V' est présente à chaque impulsion positive du courant Ip et une impulsion négative par rapport au niveau V' est présente à chaque impulsion négative du courant Ip.

La figure 9F représente l'allure du signal de sortie du comparateur 51 qui présente une impulsion positive d'amplitude V2 pendant que la tension Vs est supérieure au seuil TH1.

La figure 9G représente l'allure du signal de sortie du comparateur 52 qui présente une impulsion positive d'amplitude V2 pendant que la tension Vs est inférieure au seuil TH2.

La figure 9H représente l'allure du signal Vout en sortie de la bascule 53.

Un avantage de la présente invention est qu'un seul transformateur suffit pour réaliser l'isolement galvanique.

Un autre avantage est que la barrière d'isolement n'est pas limitée à une fenêtre d'observation pour distinguer des fronts successifs. Chaque impulsion présente sur le signal de sortie représente un front dans le sens inverse par rapport au front précédent simplifiant ainsi le système de décodage.

Bien entendu, la présente invention est susceptible de diverses variantes et modifications qui apparaîtront à l'homme de l'art. En particulier, les dimensionnements des différents composants utilisés en fonction de l'application sont à la portée de l'homme du métier à partir des indications fonctionnelles données ci-dessus.

De plus, d'autres circuits de codage pourront être prévus. Par exemple, les portes 73 et 77 peuvent être remplacées par des portes de type NON-ET si les circuits 78 et 79 comportent des nombres impairs d'inverseurs. Selon une autre variante, les condensateurs C72 et C76 sont omis et remplacés par un retard de propagation (par exemple au moyens d'inverseurs en série) des signaux fournis sur les premières entrées des portes 73 et 77 par rapport au signal Vin fourni sur leurs deuxièmes entrées.

## Revendications

1. Procédé de transfert d'un signal numérique (Vin) à travers un transformateur (11), **caractérisé en ce que** :
le signal numérique à transférer est codé (31, 32) pour générer une impulsion dans un premier sens à chaque front montant du signal à transférer et une impulsion dans un deuxième sens à chaque front descendant de ce signal ; et
à appliquer les impulsions générées à un enroulement primaire (11p) du transformateur, le courant (Ip) dans cet enroulement étant dans un sens différent selon le front montant ou descendant du signal numérique à transférer.

2. Procédé selon l'une quelconque des revendications 1 et 2, dans lequel des fronts respectivement montants et descendants d'un signal de sortie (Vout) sont générés selon le sens du courant (Is) dans un enroulement secondaire (11s) du transformateur (11).

3. Système de transfert d'un signal numérique (Vin) à travers un transformateur (11), **caractérisé en ce qu'**il comporte :
un circuit (31, 32) de codage du signal numérique à transférer, dont deux sorties sont reliées aux extrémités respectives d'un enroulement primaire (11p) du transformateur, le circuit comportant un premier inverseur (71) associé à une première porte logique (73) pour générer des impulsions sur les fronts montants et des deuxième (74) et troisième (75) inverseurs associés à une deuxième porte logique (77) pour générer des impulsions sur les fronts descendants, les sorties respectives des premier et troisième inverseurs étant reliées à une ligne d'alimentation positive (V1) par des condensateurs (C72, C76) ; et
un circuit de décodage (33) du courant dans un enroulement secondaire (11s) du transformateur générant un front montant, respectivement descendant, d'un signal de sortie (Vout) selon le sens d'impulsions de courant détectées.

4. Système selon la revendication 3 , dans lequel le circuit de décodage (33) comporte deux comparateurs (51, 52) dont les sorties sont reliées aux entrées respectives de mise à un (S) et de remise à zéro (R) d'une bascule (53) dont une sortie (D) fournit le signal numérique transféré (Vout).
